# EUROPEAN PATENT APPLICATION

(11) **EP 4 571 392 A1**
(43) Date of publication of application: **18.06.2025**
(21) Application number: 23865758.9
(22) Date of filing: 25.08.2023
(51) Int. Cl.: G02B 27/01, G06F 1/20, G06F 1/16, G06F 1/3203, H05K 7/20

(54) **ELECTRONIC DEVICE AND METHOD FOR DISSIPATING HEAT FROM PLURALITY OF HEAT SOURCES**

(30) Priority: 13.09.2022 KR 20220115252; 30.09.2022 KR 20220125539
(71) Applicant: Samsung Electronics Co., Ltd., Suwon-si, Gyeonggi-do 16677 (KR)
(72) Inventor: KIM, Musul, Suwon-si Gyeonggi-do 16677 (KR); YOON, Jongmin, Suwon-si Gyeonggi-do 16677 (KR); JUNG, Sangchul, Suwon-si Gyeonggi-do 16677 (KR)
(74) Representative: HGF
(86) International application number: PCT/KR2023/012661
(87) International publication number: WO 2024/058459

(57) **Abstract**

A wearable device according to one embodiment may comprise: a housing; a first display disposed in one area of the housing; a second display disposed in another area of the housing; a heatsink; a first application processor; a second application processor; the heatsink disposed to face the first application processor and the second application processor; a first fan corresponding to the first application processor; a second fan corresponding to the second application processor; a third fan corresponding to the first display; and a fourth fan corresponding to the second display.

## Description

### [Technical Field]

The following descriptions relate to an electronic device and a method for dissipating heat from a plurality of heat sources.

### [Background Art]

A wearable device (e.g., a head-mounted display (HMD)) for providing a virtual image may output an augmented reality (AR) image, a virtual reality (VR) image, or mixed reality (MR) in which augmented reality and virtual reality are mixed. The wearable device for providing the virtual image may include a plurality of heat sources internally.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

According to an embodiment, a wearable device may comprise a housing, a first display disposed in a region of the housing, a second display disposed in another region of the housing, a heatsink, the first application processor, the second application processor, and the heatsink disposed to face the first application processor and the second application processor, a first fan corresponding to the first application processor, a second fan corresponding to the second application processor, a third fan corresponding to the first display, and a fourth fan corresponding to the second display. The wearable device may comprise a housing. The wearable device may comprise a first display disposed in a region of the housing. The wearable device may comprise a second display disposed in another region of the housing. The wearable device may comprise a heatsink. The wearable device may comprise a first application processor. The wearable device may comprise a second application processor. The wearable device may comprise the heatsink disposed to face the first application processor and the second application processor. The wearable device may comprise a first fan corresponding to the first application processor. The wearable device may comprise a second fan corresponding to the second application processor. The wearable device may comprise a third fan corresponding to the first display. The wearable device may comprise a fourth fan corresponding to the second display. The housing may comprise a first opening, a second opening, a third opening, and a fourth opening. The housing may comprise the first opening. The housing may comprise the second opening. The housing may comprise the third opening. The housing may comprise the fourth opening.

According to an embodiment, a wearable device may comprise a housing, a first display disposed in a region of the housing, a second display disposed in another region of the housing, a heatsink, an application processor for executing functions of the wearable device, the heatsink disposed to face the application processor, a first fan corresponding to the application processor, a second fan corresponding to the first display, and a third fan corresponding to the second display. The wearable device may comprise a housing. The wearable device may comprise a first display disposed in a region of the housing. The wearable device may comprise a second display disposed in another region of the housing. The wearable device may comprise a heatsink. The wearable device may comprise an application processor. The wearable device may comprise the heatsink disposed to face the application processor. The wearable device may comprise a first fan corresponding to the application processor. The wearable device may comprise a second fan corresponding to the first display. The wearable device may comprise a third fan corresponding to the second display. The housing may comprise a first opening, a second opening, a third opening, and a fourth opening. The housing may comprise the first opening. The housing may comprise the second opening. The housing may comprise the third opening. The housing may comprise the fourth opening.

According to an embodiment, a wearable device may comprise a first application processor, a second application processor, a first fan corresponding to the first application processor, and a second fan corresponding to the second application processor. The first application processor may be configured to operate the first fan based on identifying a variable measurement value of the first application processor being equal to or greater than a first threshold. The first application processor may be configured to operate a second fan based on identifying a variable measurement value of the second application processor being equal to or greater than a second threshold. The first application processor may be configured to operate the first fan and the second fan based on identifying the variable measurement value of the first application processor being equal to or greater than a third threshold. The third threshold may be greater than the first threshold.

According to an embodiment, a method executed by a wearable device may comprise operating a first fan based on identifying a variable measurement value of a first application processor being equal to or greater than a first threshold. The method may comprise operating a second fan based on identifying a variable measurement value of a second application processor being equal to or greater than a second threshold. The method may comprise rotating the first fan and the second fan based on identifying the variable measurement value of the first application processor being equal to or greater than a third threshold. The third threshold may be greater than the first threshold.

### [Description of the Drawings]

FIG. 1 is a block diagram of an electronic device in a network environment according to various embodiments.
FIG. 2 illustrates a functional configuration of a wearable device for providing a virtual image according to an embodiment.
FIG. 3 illustrates an example of a wearable device for providing a virtual image according to an embodiment.
FIG. 4 illustrates an example of a wearable device for providing a virtual image including a heat dissipation structure according to an embodiment.
FIG. 5 illustrates an example of a wearable device for providing a virtual image including a heat dissipation structure according to an embodiment.
FIG. 6 illustrates a flow of an operation of an electronic device for operating a fan according to an embodiment.
FIG. 7 illustrates a degree of radiation corresponding to the number of fans according to an embodiment.

### [Mode for Invention]

Terms used in the present disclosure are used only to describe a specific embodiment, and may not be intended to limit scope of another embodiment. A singular expression may include a plural expressions unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since various embodiments of the present disclosure include technology that uses both hardware and software, the various embodiments of the present disclosure do not exclude a software-based approach.

A term referring to combination (e.g., combination, merging, and montaging), a term referring to a virtual image (e.g., an image of virtual reality, an image of augmented reality, and an image of mixed reality), a term referring to an inlet (e.g., an entrance, a hole, and an opening), a term referring to an outlet (e.g., an exit, a hole, and an opening), a term referring to an application processor (an application processor, a processor, and an application processor (AP)), a term referring to a specified value (e.g., a reference value, and a threshold value), and the like, used in the following description are exemplified for convenience of explanation. Therefore, the present disclosure is not limited to terms described below, and other terms having equivalent technical meanings may be used. In addition, terms ' '...unit,' '...device,' '...object,' and '...body', and the like used below may mean at least one shape structure or a unit that processes a function.

In addition, in the present disclosure, a term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' means at least one of elements from A (including A) to B (including B). Hereinafter, 'C' and/or 'D' means that at least one of 'C' or 'D', that is, {'C', 'D', 'C' and 'D'}.

Prior to describing embodiments of the present disclosure, the terms necessary to describe operations of an electronic device according to embodiments are defined.

A wearable device for providing the virtual image refers to a device that displays virtual images such as virtual reality (VR), augmented reality (AR), and mixed reality (MR). For example, the wearable device for providing the virtual image may include a head-mounted display (HMD).

The virtual image may mean as an image indicating virtual reality such as the virtual reality (VR), the augmented reality (AR), and mixed reality (MR).

Hereinafter, various embodiments disclosed in the present document will be described with reference to an attached drawing. For convenience of explanation, elements illustrated in the drawing may be exaggerated or reduced in their sizes, and the present invention is not necessarily limited thereto as the illustrated.

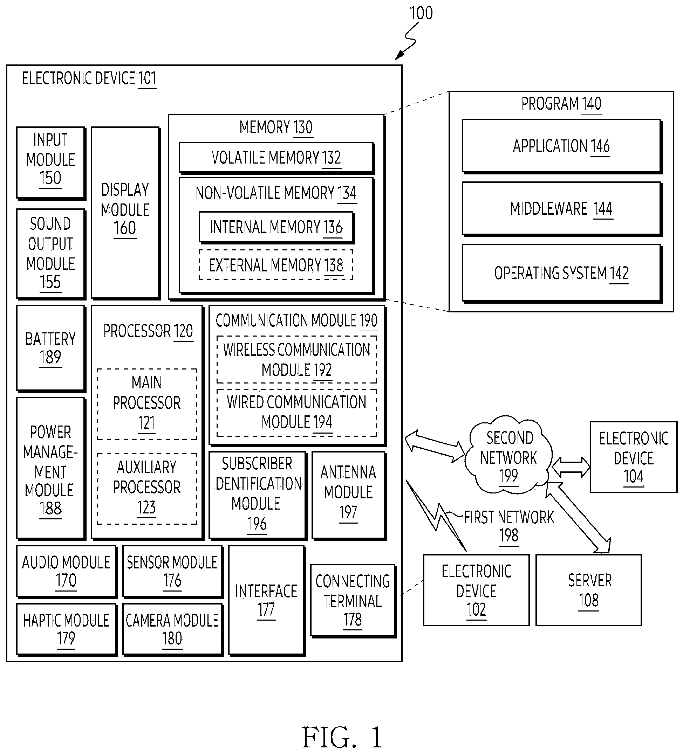

FIG. 1 is a block diagram of an electronic device in a network environment according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

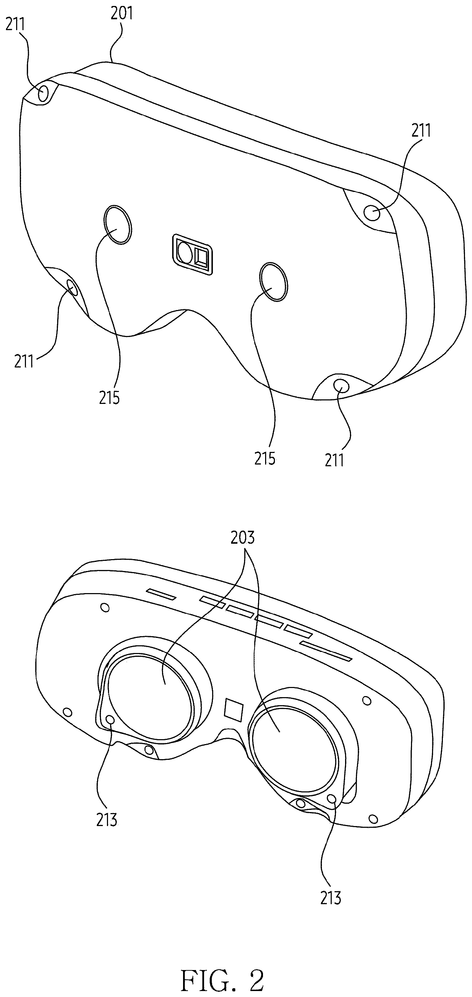

FIG. 2 illustrates a functional configuration of a wearable device for providing a virtual image according to an embodiment.

Referring to FIG. 2, a wearable device 201 for providing the virtual image may be in a shape closely contacted with eyes of the user in case that the wearable device is worn by a user. A display 203 may display the virtual image. A first camera unit 211, a second camera unit 213, and a third camera unit 215 may be included in the wearable device 201 for providing the virtual image.

According to an embodiment, the wearable device 201 for providing the virtual image may be referred to as a wearable device worn on a part of a body of the user. The wearable device 201 for providing the virtual image may be configured to provide the user with augmented reality (AR), virtual reality (VR), or mixed reality (MR) in which the augmented reality and the virtual reality are mixed. For example, the wearable device 201 for providing the virtual image may receive data related to an image from the outside of the wearable device 201 for providing the virtual image. The wearable device 201 for providing the virtual image may provide the virtual image through at least one display based on the data related to the received image. For example, a virtual image provided by the wearable device 201 for providing the virtual image may include still vision and a video to implement the virtual reality. For example, the wearable device 201 for providing the virtual image may provide the augmented reality that overlappingly displays a virtual object on a reality image implemented by light obtained through a camera. The reality image may mean an image or a video implemented by the light received from the outside of the wearable device 201 for providing the virtual image, without separate data processing by the wearable device 201 to provide the virtual image. The virtual object may include at least one of text and an image corresponding to various information related to an object included in the reality image. However, it is not limited thereto, and the virtual object may include at least one of text and an image corresponding to various information related to another object distinguished from the object included in the reality image.

For example, the display 203 may include a liquid crystal display (LCD), a digital mirror device (DMD), a liquid crystal on silicon (LCos), an organic light emitting diode (OLED), or a micro light emitting diode (micro LED). Although not illustrated, in case that the display 203 is composed of one of the liquid crystal display, the digital mirror device, or the liquid crystal on silicon, the wearable device 201 for providing the virtual image may include a light source that irradiates light to a screen output region of the display 203. In another embodiment, in case that the display 203 is capable of generating light by itself, for example, in case that the display 203 is composed of one of the organic light emitting diode or the micro light emitting diode, the wearable device 201 for providing the virtual image may provide a good quality virtual video to the user, even without including a separate light source. In an embodiment, since the light source is unnecessary if the display 203 is implemented as the organic light emitting diode or the micro light emitting diode, the wearable device 201 for providing the virtual image may be lightweight. The wearable device 201 for providing the virtual image may include the display 203. The user may use the wearable device 201 for providing the virtual image, in a state of wearing the wearable device 201 on a face of the user. A first transparent member and/or a second transparent member may be formed of a glass plate, a plastic plate, or a polymer, and may be manufactured to be transparent or translucent. According to an embodiment, the first transparent member may be disposed to face a right eye of the user, and the second transparent member may be disposed to face a left eye of the user. According to various embodiments, in case that the display 203 is transparent, the display 203 may be disposed at a position facing the eyes of the user to configure a screen display unit. A lens may serve to adjust a focus of a screen outputted to the display. For example, the lens may be a fresnel lens. The lens may be a pancake lens. The lens may be a multichannel lens.

The first camera unit 211 may include a recognition camera. The recognition camera may be used for head tracking and spatial recognition of a 3 degree of freedom (DOF), a 6 degree of freedom (6 DOF). The recognition camera may be a global shutter (GS) camera. Since a stereo camera is required for the head tracking and the space recognition, two or more GS cameras may be used. The GS camera may detect a fast motion and a fine motion. The GS camera may reduce a motion blur phenomenon. The first camera unit 211 may perform the spatial recognition for the 6 degree of freedom (6 DOF) and a simultaneous localization and mapping (SLAM) function through depth shooting. Also, the first camera unit 211 may perform a user gesture recognition function.

The second camera unit 213 may include an eye tracking (ET) camera. The eye tracking (ET) camera may detect and track a pupil. The ET camera may be used for purpose of positioning a center of a virtual video projected on augmented reality (AR) glasses according to a direction in which the pupil of AR glasses wearer are staring. The second camera unit 213 may include the global shutter (GS) camera to detect the pupil and track a fast pupil movement. The GS camera may detect the fast motion and the fine motion. The GS camera may reduce the motion blur phenomenon. The ET camera may be installed for the left eye and the right eye, respectively. The performance and a standard of the left eye camera and the right eye camera may be the same.

The third camera unit 215 may include a camera for shooting. The third camera unit 215 is referred to as a high resolution (HR) or a photo video (PV), and a high resolution camera may be used. The third camera unit 215 may be used as a camera equipped with functions for obtaining high-quality images such as an auto-focus (AF) function, an optical image stabilization (OIS), and the like. The third camera unit 215 may be the GS camera. The third camera unit 215 may be a rolling shutter (RS) camera. A light detection and ranging (Lidar) sensor may be disposed instead of the camera at a position where the third camera unit 215 is disposed.

The wearable device 201 for providing the virtual image may include a microphone, an SPK, a battery, an antenna, and a sensor. The sensor may include an acceleration sensor, a gyro sensor, and a touch sensor.

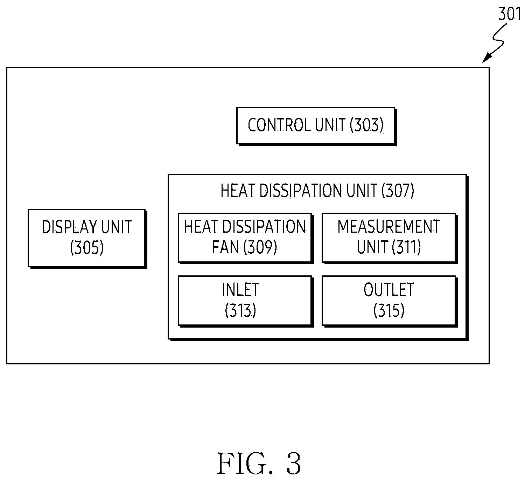

FIG. 3 illustrates an example of a wearable device for providing a virtual image according to an embodiment.

Referring to FIG. 3, a wearable device 301 for providing a virtual image may include a control unit 303, a display unit 305, and a heat dissipation unit 307. The heat dissipation unit 307 may include a heat dissipation fan 309, a measurement unit 311, an inlet 313, and an outlet 315.

The wearable device 301 (e.g., the electronic device 101 of FIG. 1) for providing the virtual image may include the control unit 303. The control unit 303 may be an element for controlling each portions of the wearable device 301 for providing the virtual image. The wearable device 301 for providing the virtual image may control elements of the wearable device 301 for providing the virtual image through the control unit 303.

According to an embodiment, the control unit 303 may display the virtual image on the display unit 305, based on identifying a signal transmitted from an external wearable device. The virtual image refers to an image indicating virtual reality such as virtual reality (VR), augmented reality (AR), and mixed reality (MR).

The wearable device 301 may include a plurality of heating sources (e.g., a first application processor, a second application processor, a first display, and a second display). Heat generated by the plurality of heat sources may reduce a performance of the wearable device 301 by being transfferd to an electronic component (e.g., circuits close to the first application processor, circuits close to the second application processor, circuits close to the first display, and circuits close to the second display). In addition, the heat from the plurality of heat sources may reduce wearability, by being transferred to the outside of the wearable device 301. The heat generated by the plurality of heat sources may be emitted to the outside by wind caused by a fan.

According to an embodiment, the control unit 303 may control the heat dissipation fan 309 based on a temperature value of the electronic component (e.g., the first application processor, the second application processor, the first display, and the second display) measured through the measurement unit 311. For example, in case that a temperature value of a first component (e.g., the first application processor) is equal to or greater than a first threshold, the control unit 303 may operate (actuate) the heat dissipation fan 309 corresponding to the first component. The heat dissipation fan 309 corresponding to the first component may be disposed close to the first component for heat dissipation of the first component. For example, in case that a temperature value of a second component (e.g., the second application processor) is equal to or greater than a second threshold, the control unit 303 may operate the heat dissipation fan 309 corresponding to the second component. The heat dissipation fan 309 corresponding to the second component may be disposed close to the second component for heat dissipation of the second component. For example, the control unit 303 may operate the heat dissipation fan 309 corresponding to the first component and the heat dissipation fan 309 corresponding to the second component, based on identifying the temperature value of the first component equal to or greater than a third threshold. The third threshold may be greater than the first threshold. The heat dissipation fan 309 corresponding to the second component may operate in case that the temperature value of the first component is equal to or greater than the third threshold even if the temperature value of the second component is less than the second threshold. That is, the heat dissipation fan 309 corresponding to the second component may operate to lower the temperature value of the first component. For example, the control unit 303 may operate the heat dissipation fan 309 corresponding to the first component and the heat dissipation fan 309 corresponding to the second component based on identifying the temperature value of the second component equal to greater than a fourth threshold. The fourth threshold may be greater than the second threshold. The heat dissipation fan 309 corresponding to the first component may operate in case that the temperature value of the second component is equal to or greater than the fourth threshold, even if the temperature value of the first component is less than the first threshold. That is, the heat dissipation fan 309 corresponding to the first component may operate to lower the temperature value of the second component.

According to an embodiment, the control unit 303 may control the heat dissipation fan 309 based on a power consumption of the electronic component. For example, the control unit 303 may operate the heat dissipation fan 309 corresponding to the first component, in case that a power consumption of the first component (e.g., the first application processor) is equal to or greater than the first threshold. For example, the control unit 303 may operate the heat dissipation fan 309 corresponding to the second component in case that a power consumption of the second component (e.g., the second application processor) is equal to or greater than the second threshold. For example, the control unit 303 may operate the heat dissipation fan 309 corresponding to the first component and the heat dissipation fan 309 corresponding to the second component, based on identifying the power consumption of the first component equal to or greater than the third threshold. The third threshold may be greater than the first threshold. The heat dissipation fan 309 corresponding to the second component may operate in case that the temperature value of the first component is equal to or greater than the third threshold, even if the power consumption of the second component is less than the second threshold. That is, the heat dissipation fan 309 corresponding to the second component may operate to lower the temperature value of the first component.

For example, the control unit 303 may operate the heat dissipation fan 309 corresponding to the first component and the heat dissipation fan 309 corresponding to the second component based on identifying the power consumption of the second component equal to or greater than the fourth threshold. The fourth threshold may be greater than the second threshold. The heat dissipation fan 309 corresponding to the first component may operate, in case that the power consumption of the second component is equal to or greater than the fourth threshold, even if the power consumption of the first component is less than the first threshold. That is, the heat dissipation fan 309 corresponding to the first component may operate to lower the temperature value of the second component.

According to an embodiment, the control unit 303 may control a rotational speed (e.g., revolutions per minute (RPM)) of the heat dissipation fan 309 based on the temperature value of the electronic component measured through the measurement unit 311. For example, as the temperature value of the first component (e.g., the first application processor) is higher, the control unit 303 may set the rotational speed of the heat dissipation fan 309 corresponding to the first component to be higher. For example, the control unit 303 may operate the heat dissipation fan 309 corresponding to the first component with a first rotational speed based on a first temperature of the first component. The control unit 303 may operate the heat dissipation fan 309 corresponding to the first component with a second rotational speed faster than the first rotational speed based on a second temperature of the first component higher than the first temperature. For example, as the temperature value of the second component (e.g., the second application processor) is higher, the control unit 303 may set the rotational speed of the heat dissipation fan 309 corresponding to the second component to be higher. For example, the control unit 303 may operate the heat dissipation fan 309 corresponding to the second component with a third rotational speed based on a third temperature of the second component. For example, the control unit 303 may operate the heat dissipation fan 309 corresponding to the second component with a fourth rotational speed faster than the third rotational speed based on a fourth temperature of the second component.

According to an embodiment, the control unit 303 may control the rotational speed of the heat dissipation fan 309 based on the power consumption of the electronic component. For example, as the power consumption of the first component (e.g., the first application processor) increases, the control unit 303 may set the rotational speed of the heat dissipation fan 309 corresponding to the first component to be higher. For example, the control unit 303 may operate the heat dissipation fan 309 corresponding to the first component with the first rotational speed based on a first power consumption of the first component. The control unit 303 may operate the heat dissipation fan 309 corresponding to the first component with the second rotational speed faster than the first rotational speed based on a second power consumption of the first component greater than the first power consumption. For example, as the power consumption of the second component (e.g., the second application processor) increases, the control unit 303 may set the rotational speed of the heat dissipation fan 309 corresponding to the second component 309 to be higher. For example, the control unit 303 may operate the heat dissipation fan 309 corresponding to the second component with the third rotational speed based on a third power consumption of the second component. The control unit 303 may operate the heat dissipation fan 309 corresponding to the second component with the fourth rotational speed faster than the third rotational speed based on a fourth power consumption of the second component greater than the third power consumption.

According to an embodiment, the control unit 303 may identify active fan information corresponding to an identified application. The control unit 303 may operate the heat dissipation fan 309 included in the active fan information. The heat dissipation fan may operate at a rotational speed of a first step, a second step, and a third step. The rotational speed may be fast in an order of the third step, the second step, and the first step. For example, when watching a video, a first fan may operate with a rotational speed of the second step. When watching the video, a second fan may not operate. When watching the video, a third fan and a fourth fan may operate with the rotational speed of the second step.

According to an embodiment, at least one processor 120 may activate a portion of a plurality of heat dissipation fans based on a type of an application in execution. For example, when a low load application is being executed, the at least one processor 120 may rotate only one of the first fan, the second fan, the third fan, and the fourth fan.

According to an embodiment, the at least one processor 120 may activate a portion of the plurality of heat dissipation fans based on at least one of an AP share (occupancy rate), a CPU share, or a GPU share. For example, the at least one processor 120 may activate a portion of the plurality of heat dissipation fans based on the AP share.

According to an embodiment, the at least one processor 120 may activate a portion of the plurality of heat dissipation fans based on a clock.

The wearable device 301 for providing the virtual image may include a display unit 305. The display unit 305 may be an element for displaying the virtual image. The display unit may include at least one display. For example, the display unit 305 may be configured to provide visual information. For example, the display unit 305 may be configured to emit light, based on receiving data for displaying an image from the control unit 303. The display unit 305 may be electrically connected to a printed circuit board. For example, the display unit 305 may provide a virtual image through the at least one display, based on receiving data related to an image from the outside of the wearable device 201 for providing the virtual image. For example, the virtual image may include still vision and a video to implement the virtual reality. For example, the display unit 305 may overlappingly display a virtual object on a reality image implemented by light obtained through a camera of the wearable device 201 for providing the virtual image. The reality image may mean the image or the video implemented by the light obtained through the camera without separate data processing. The virtual object may include at least one of text and an image corresponding to information related to an object included in the reality image. However, it is not limited thereto, and the virtual object may include at least one of text and an image corresponding to various information related to another object distinguished from the object included in the reality image.

The wearable device 301 for providing the virtual image may include the heat dissipation unit 307. The heat dissipation unit 307 may be an element for emitting heat. The heat dissipation unit 307 may emit the heat generated by a plurality of heat sources. The heat dissipation unit 307 may include the heat dissipation fan 309, the measurement unit 311, the inlet 313, and the outlet 315. The heat dissipation fan 309 may rotate to emit the heat from an electronic component. The measurement unit 311 may identify a variable measurement value of the electronic component. The variable may be measured to reflect a degree to which heat is generated in the electronic component. For example, the variable may be a temperature. This is because, as the temperature value of the electronic component is higher, the heat generated by the electronic component increases. For example, the variable may be a power consumption. This is because, as the power consumption of the electronic component is greater, the heat generated by the electronic component increases. The heat dissipation unit 307 may include the inlet 313. The inlet 313 may pass air outside the wearable device 301 for providing the virtual image by airflow generated by the heat dissipation fan 309. The air introduced through the inlet 313 may pass through the electronic component (e.g., a display, and a heat sink) to cool the electronic component. The air passing through the electronic component may be discharged to the outside of the wearable device 301 for providing the virtual image through the outlet 315. The heat dissipation unit 307 may include the outlet 315. The air passing through the electronic component by the airflow generated by the heat dissipation fan 309 may be discharged to the outside of the wearable device 301 for providing the virtual image through the outlet 315.

Although not illustrated in FIG. 3, the heat dissipation unit 307 may include a heat sink. The heat sink may emit the heat generated from the printed circuit board to the outside of the wearable device 301. The heat sink may emit the heat to the outside of the wearable device 301 through conduction, convection, or radiation. According to an embodiment, the heat sink may be disposed to face a surface of the printed circuit board. For example, the heat sink may be disposed toward or be in contacted with a portion (e.g., an application processor) of the electronic components disposed on the surface of the printed circuit board. According to an embodiment, the printed circuit board may be disposed such that a region of the printed circuit board faces the heat sink. According to an embodiment, among a plurality of electronic components disposed in the printed circuit board, electronic components having a relatively high amount of heat generation may be disposed in a region of the printed circuit board. For example, the electronic component disposed in a first region of the printed circuit board may include a processor. As the heat sink is disposed to face the region of the printed circuit board, the heat generated from the electronic components of the printed circuit board may be emitted to the outside of a housing. According to an embodiment, the heat sink may pass the airflow generated by the heat dissipation fan 309. The heat sink may emit the heat transferred from the airflow generated by the heat dissipation fan 309 to the outside of the wearable device 301 for providing the virtual image.

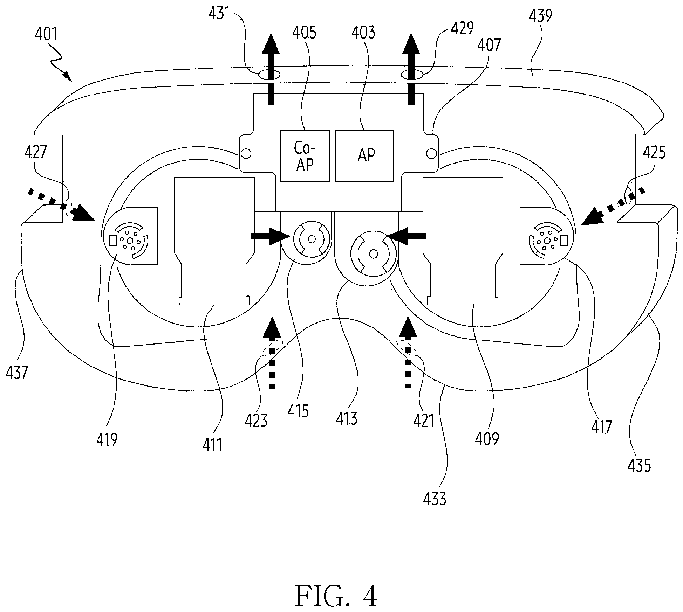

FIG. 4 illustrates an example of a wearable device for providing a virtual image including a heat dissipation structure according to an embodiment. The wearable device for providing the virtual image may be worn on a part of a body of a user.

Referring to FIG. 4, a wearable device 401 (e.g., the electronic device 101 of FIG. 1) for providing the virtual image may include a first application processor 403, a second application processor 405, a heat sink 407, a first display 409, a second display 411, a first fan 413, a second fan 415, a third fan 417, a fourth fan 419, a first opening 421, a second opening 423, a third opening 425, a fourth opening 427, a fifth opening 429, and/or a sixth opening 431. A housing of the wearable device 401 may include a first side surface 433, a second side surface 435, a third side surface 437, and a fourth side surface 439.

According to an embodiment, the housing of the wearable device 401 may accommodate a plurality of elements of the wearable device 401 for providing the virtual image. The housing may be disposed to surround the plurality of elements of the wearable device 401 for providing the virtual image. When the wearable device 401 for providing the virtual image is worn by the user, a first surface of the housing may face a face of the user. The first surface of the housing may include a display (the first display 409 or the second display 411) of the wearable device for providing the virtual image. A second surface of the housing may be opposite to the first surface of the housing. The second surface of the housing may be a surface spaced apart from the first surface of the housing.

According to an embodiment, a side surface (e.g., the first side surface 433, the second side surface 435, the third side surface 437, or the fourth side surface 439) of the housing may connect the first surface of the housing to the second surface of the housing. The side surface (e.g., the first side surface 433, the second side surface 435, the third side surface 437, or the fourth side surface 439) of the housing may be bent with a specified curvature, but it is not limited thereto. As an example, a side surface (e.g., the first side surface 433, the second side surface 435, the third side surface 437, or the fourth side surface 439) of the housing may be perpendicular to the first surface of the housing and the second surface of the housing.

When the user wears the wearable device 401 for providing the virtual image, the first side surface 433 may face a lower end (e.g., ground) with respect to the user. When the user wears the wearable device 401 for providing the virtual image, the fourth side surface 439 may face an upper end (e.g., sky) with respect to the user.

According to an embodiment, the housing of the wearable device 401 may include one or more inlets. The housing of the wearable device 401 may include the first opening 421, the second opening 423, the third opening 425, and the fourth opening 427. The first opening 421 may connect the outside of the housing and the inside of the housing. The first opening 421 may be an inlet through which air outside the housing is transferred to the inside of the housing. According to an embodiment, the first opening 421 may be formed to penetrate (transpierce) the first side surface 433 of the housing. The first opening 421 may be disposed on the first side surface 433. The second opening 423 may connect the outside of the housing and the inside of the housing. The second opening 423 may be an inlet through which air outside the housing is transferred to the inside of the housing. According to an embodiment, the second opening 423 may be formed to penetrate the first side surface 433 of the housing. The second opening 423 may be disposed on the first side surface 433. The third opening 425 may connect the outside of the housing and the inside of the housing. The third opening 425 may be an inlet through which air outside the housing is transferred to the inside of the housing. According to an embodiment, the third opening 425 may be formed to penetrate the second side surface 435 of the housing. The third opening 425 may be disposed on the second side surface 435. The fourth opening 427 may connect the outside of the housing and the inside of the housing. The fourth opening 427 may be an inlet through which air outside the housing is transferred to the inside of the housing. According to an embodiment, the fourth opening 427 may be formed to penetrate the third side surface 437 of the housing. The fourth opening 427 may be disposed on the third side surface 437.

According to an embodiment, the housing of the wearable device 401 may include one or more outlets. The housing of the wearable device 401 may include the fifth opening 429 and the sixth opening 431. The fifth opening 429 may connect the outside of the housing and the inside of the housing. The fifth opening 429 may be an outlet through which air inside the housing is transferred to the outside of the housing. For example, the fifth opening 429 may transfer the air that has passed through the heat sink 407 to the outside of the housing. According to an embodiment, the fifth opening 429 may overlap the heat sink 407 when viewed from above the housing. For example, the fifth opening 429 may be formed to penetrate the fourth side surface 439 of the housing. For example, the fifth opening 429 may be disposed on the fourth side surface 439 of a region of the housing. The sixth opening 431 may connect the outside of the housing and the inside of the housing. The sixth opening 431 may be an outlet through which air inside the housing is transferred to the outside of the housing. For example, the sixth opening 431 may transfer the air that has passed through the heat sink 407 to the outside of the housing. According to an embodiment, the sixth opening 431 may overlap the heat sink 407 when viewed from above the housing. For example, the sixth opening 431 may be formed to penetrate the fourth side surface 439 of the housing. For example, the sixth opening 431 may be disposed on the fourth side surface 439 of the region of the housing.

According to an embodiment, the wearable device 401 may include a plurality of heat dissipation fans. Each heat dissipation fan (e.g., the first fan 413, the second fan 415, the third fan 417, and the fourth fan 419) may form airflow around the wearable device 401. The air outside the housing may be introduced into the inside of the housing through the inlets (e.g., the first opening 421, the second opening 423, the third opening 425, and the fourth opening 427) by the airflow generated by each heat dissipation fan. The air introduced into the housing through the inlets (e.g., the first opening 421, the second opening 423, the third opening 425, and the fourth opening 427) may be transferred to components (e.g., the first display 409, the second display 411, the first application processor 403, and/or the second application processor 405) in the housing. Heat generated in the housing may be transferred to the air introduced into the housing. The air heated in the housing may move to the heat dissipation fan (e.g., the first fan 413, the second fan 415, the third fan 417, or the fourth fan 419). As the air passes through the heat sink 407 and the outlet (e.g., the fifth opening 429, or the sixth opening 431) and is discharged to the outside of the housing, the inside of the housing may be cooled.

According to an embodiment, the heat sink 407 may emit heat generated from an electronic component to the outside of the housing of the wearable device 401. The heat sink 407 may include a plurality of pins for increasing an internal surface area. According to an embodiment, the heat sink 407 may be disposed on a surface of a printed circuit board to face at least a portion (e.g., the first application processor and the second application processor) of electronic components. According to an embodiment, among a plurality of electronic components disposed on the printed circuit board, electronic components having a relatively high amount of heat generation may be disposed at a position corresponding to the heat sink 407 inside the printed circuit board. For example, the electronic component disposed to face the heat sink 407 may include the first application processor 403. For example, the electronic component disposed to face the heat sink 407 may include the second application processor 405. As the heat sink 407 is disposed to face the electronic component included in the printed circuit board, the heat generated from the electronic components may be emitted to the outside of the housing.

According to an embodiment, the first application processor 403 may correspond to the first fan 413. The first application processor 403 may operate the first fan 413 based on a variable measurement value of the first application processor. For example, the variable may be a temperature. The first application processor 403 may operate the first fan 413 based on a temperature value of the first application processor 403 equal to or greater than a first threshold. The first application processor 403 may operate the first fan 413 with a higher rotational speed (e.g., a higher revolutions per minute (RPM)) as the temperature value of the first application processor 403 is higher. For example, the variable may be a power consumption. The first application processor 403 may operate the first fan 413 based on a power consumption of the first application processor 403 equal to or greater than the first threshold. The first application processor 403 may operate the first fan 413 with a higher rotational speed as the power consumption of the first application processor 403 increases.

According to an embodiment, the first application processor 403 may operate the second fan 415 based on the variable measurement value of the first application processor 403. For example, the variable may be a temperature. The first application processor 403 may operate the second fan 415 based on the temperature value of the first application processor 403 equal to or greater than a third threshold. The at least one processor may obtain a temperature of a corresponding electronic component through a thermistor. The first application processor 403 may correspond to a first thermistor. The second application processor 405 may correspond to a second thermistor. The at least one processor 403 and 405 may obtain a temperature of the first application processor 403 through the first thermistor. The at least one processor 403 and 405 may obtain a temperature of the second application processor 405 through the second thermistor. For example, the variable may be a power consumption. The first application processor 403 may operate the second fan 415 based on the power consumption of the first application processor 403 equal to or greater than the third threshold.

According to an embodiment, the second application processor 405 may correspond to the second fan 415. The first application processor 403 may operate the second fan 415 based on a variable measurement value of the second application processor. For example, the variable may be a temperature. The second application processor 405 may operate the second fan 415 based on a temperature value of the second application processor 405 equal to or greater than a second threshold. The first application processor 403 may operate the second fan 415 with a higher rotational speed as the temperature value of the second application processor 405 is higher. For example, the variable may be a power consumption. The first application processor 403 may operate the second fan 415 based on a power consumption of the second application processor 405 equal to or greater than the second threshold. The first application processor 403 may operate the second fan 415 with a higher rotational speed as the power consumption of the second application processor 405 increases.

According to an embodiment, the first application processor 403 may operate the first fan 413 based on the variable measurement value of the second application processor 405. For example, the variable may be a temperature. The first application processor 403 may operate the first fan 413 based on the temperature value of the second application processor 405 equal to or greater than a fourth threshold. For example, the variable may be a power consumption. The first application processor 403 may operate the first fan 413 based on the power consumption of the second application processor 405 equal to or greater than the fourth threshold.

In FIG. 4, although the wearable device for providing the virtual image is illustrated to include the third opening 425 and the fourth opening 427, embodiments of the present disclosure are not limited thereto. According to another embodiment, the wearable device for providing the virtual image may not include the third opening 425 and the fourth opening 427. The third fan 417 and the fourth fan 419 of the wearable device for providing the virtual image may be a microelectromechanical structure (MEMS) fan. Even if an amount of air inflow is small, the MEMS fan may dissipate heat with strong pressure. The MEMS fan may utilize an ultrasonic wave. The MEMS fan may discharge air introduced through the MEMS fan toward a direction of the first fan 413 or the second fan 415.

In FIG. 4, although the wearable device for providing the virtual image includes the first application processor 403 and the second application processor 405, embodiments of the present disclosure are not limited thereto. According to another embodiment, the wearable device for providing the virtual image may include memory instead of the second application processor 405. For example, the memory may be disposed instead of the second application processor 405 at a position where the second application processor 405 is disposed. According to another embodiment, the wearable device for providing the virtual image may further include the memory in addition to the first application processor 403 and the second application processor 405.

The memory and an application processor (the first application processor 403 and/or the second application processor 405) may be designed separately. The memory and the application processor may generate a significant amount of heat, by having high a power consumption. This is because when the memory and the application processor is a package on package (POP) structure, heat dissipation performance may be reduced. In the POP structure, the memory and the application processor may be arranged on the same chip. The memory and the application processor may correspond to different fans. The memory and the application processor may correspond to different thermistors. The application processor may correspond to a first thermistor. The memory may correspond to a second thermistor. The at least one processor may obtain a temperature of a component corresponding by using the thermistor. The at least one processor may obtain a temperature of the memory by using the first thermistor. The at least one processor may obtain a temperature of the application processor by using the second thermistor.

According to an embodiment, in case that the temperature of the processor of the application is equal to or greater than a specified threshold, the at least one processor may rotate both the first fan 413 for the at least one processor and the second fan 415 for the memory. In case that a memory usage rate is low, the at least one processor may rotate only the first fan 413 for the at least one processor. In case that the memory usage rate is high, the at least one processor may rotate both the first fan 413 for the at least one processor and the second fan 415 for the memory.

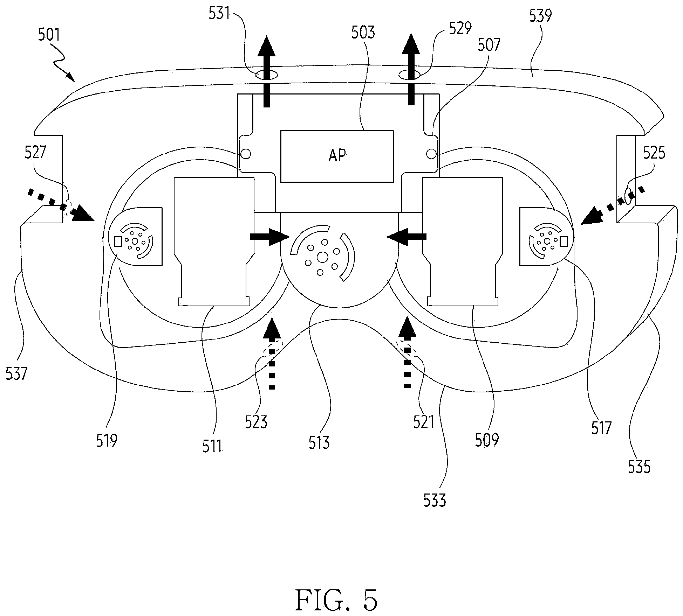

FIG. 5 illustrates an example of a wearable device for providing a virtual image including a heat dissipation structure according to an embodiment.

Referring to FIG. 5, an wearable device 501 (e.g., the electronic device 101 of FIG. 1) for providing a virtual image may include an application processor 503, a heat sink 507, a first display 509, a second display 511, a first fan 513, a second fan 517, a third fan 519, a first opening 521, a second opening 523, a third opening 525, a fourth opening 527, a fifth opening 529, and/or a sixth opening 531. A housing may include a first side surface 533, a second side surface 535, a third side surface 537, and a fourth side surface 539.

According to an embodiment, the housing of the wearable device 501 may accommodate a plurality of elements of the wearable device 501 for providing the virtual image. The housing of the wearable device 501 may be disposed to surround the plurality of elements of the wearable device 501 for providing the virtual image. When the wearable device 501 for providing the virtual image is worn by the user, the first surface of the housing may be disposed to face a face of a user. The first surface may include a display (the first display 509 or the second display 511) of the wearable device for providing the virtual image. A second surface of the housing may be opposite to the first surface of the housing. The second surface may be a surface spaced apart from the first surface of the housing.

According to an embodiment, a side surface (e.g., the first side surface 533, the second side surface 535, the third side surface 537, or the fourth side surface 539) of the housing may connect the first surface of the housing to the second surface of the housing. The side surface (e.g., the first side surface 533, the second side surface 535, the third side surface 537, or the fourth side surface 539) of the housing may have a specified curvature and may be bent, but is not limited thereto. As an example, the side surface (e.g., the first side surface 533, the second side surface 535, the third side surface 537, or the fourth side surface 539) of the housing may be perpendicular to the first surface of the housing and the second surface of the housing.

When the user wears the wearable device 501 for providing the virtual image, the first side surface 533 may face a lower end (e.g., ground) with respect to the user. When the user wears the wearable device 501 for providing the virtual image, the fourth side surface 539 may face an upper end (e.g., sky) with respect to the user.

According to an embodiment, the housing of the wearable device 501 may include one or more inlets. The housing of the wearable device 501 may include the first opening 521, the second opening 523, the third opening 525, and the fourth opening 527. The first opening 521 may connect the outside of the housing and the inside of the housing. The first opening 521 may be an inlet through which air outside of the housing is transferred to the inside of the housing. According to an embodiment, the first opening 521 may be formed to penetrate the first side surface 533 of the housing. The first opening 521 may be disposed on the first side surface 533. The second opening 523 may connect the outside of the housing and the inside of the housing. The second opening 523 may be an inlet through which the air outside the housing is transferred to the inside of the housing. According to an embodiment, the second opening 523 may be formed to penetrate the first side surface 533 of the housing. The second opening 523 may be disposed on the first side surface 533. The third opening 525 may connect the outside of the housing and the inside of the housing. The third opening 525 may be an inlet through which the air outside the housing is transferred to the inside of the housing. According to an embodiment, the third opening 525 may be formed to penetrate the second side surface 535 of the housing. The third opening 525 may be disposed on the second side surface 535. The fourth opening 527 may connect the outside of the housing and the inside of the housing. The fourth opening 527 may be an inlet through which the air outside the housing is transferred to the inside of the housing. According to an embodiment, the fourth opening 527 may be formed to penetrate the third side surface 537 of the housing. The fourth opening 527 may be disposed on the third side surface 537.

According to an embodiment, the housing of the wearable device 501 may include one or more outlets. The housing of the wearable device 501 may include the fifth opening 529 and the sixth opening 531. The fifth opening 529 may connect the outside of the housing and the inside of the housing. The fifth opening 529 may be an outlet through which air inside the housing is transferred to the outside of the housing. For example, the fifth opening 529 may transfer the air that has passed through the heat sink 507 to the outside of the housing. According to an embodiment, the fifth opening 529 may overlap the heat sink 507 when viewed from above the housing. For example, the fifth opening 529 may be formed to penetrate the fourth side surface 539 of the housing. For example, the fifth opening 529 may be disposed on the fourth side surface 539 of a region of the housing. The sixth opening 531 may connect the outside of the housing and the inside of the housing. The sixth opening 531 may be an outlet through which the air inside the housing is transferred to the outside of the housing. For example, the sixth opening 531 may transfer air that has passed through the heat sink 507 to the outside of the housing. According to an embodiment, the sixth opening 531 may overlap the heat sink 507 when viewed from above the housing. For example, the sixth opening 531 may be formed to penetrate the fourth side surface 539 of the housing. For example, the sixth opening 531 may be disposed on the fourth side surface 539 of the region of the housing.

According to an embodiment, the wearable device 501 may include a plurality of heat dissipation fans. Each fan (e.g., the first fan 513, the second fan 517, and the third fan 519) may form airflow around the wearable device 501. The air outside the housing may be introduced into the inside of the housing through the inlets (e.g., the first opening 521, the second opening 523, the third opening 525, and the fourth opening 527) by the airflow generated by each heat dissipation fan. The air introduced into the housing through the inlets (e.g., the first opening 521, the second opening 523, the third opening 525, and the fourth opening 527) may be transferred to components (e.g., the first display 509, the second display 511, and/or the application processor 503) in the housing. Heat generated in the housing may be transferred to the air introduced into the housing. The air heated in the housing may move to the heat dissipation fan (e.g., the first fan 513, the second fan 517, or the third fan 519). As air passes through the heat sink 507 and the outlet (e.g., the fifth opening 529, or the sixth opening 531), and is discharged to the outside of the housing, the inside of the housing may be cooled.

According to an embodiment, the heat sink 507 may emit heat generated from an electronic component to the outside of the housing of the wearable device 501. For example, the heat sink 507 may include a plurality of pins for increasing an internal surface area. According to an embodiment, the heat sink 507 may be disposed on a surface of a printed circuit board to face at least a portion (e.g., an application processor) of the electronic components. According to an embodiment, among a plurality of electronic components disposed on the printed circuit board, electronic components having a relatively high amount of heat generation may be disposed at a position corresponding to the heat sink 507 inside the printed circuit board. For example, the electronic component disposed to face the heat sink 507 may include the application processor 503. As the heat sink 507 is disposed to face the electronic component included in the printed circuit board, heat generated from the electronic components may be emitted to the outside of the housing.

According to an embodiment, the application processor 503 may correspond to the first fan 513. The application processor 503 may operate the first fan 513 based on a variable measurement value of the application processor. For example, the variable may be a temperature. The application processor 503 may operate the first fan 513 based on a temperature value of the application processor 503 equal to or greater than a first threshold. The application processor 503 may operate the first fan 513 with a higher rotational speed (e.g., a higher revolutions per minute (RPM) as the temperature value of the application processor 503 is higher. The at least one processor 503 may obtain a temperature of a corresponding electronic component through a thermistor. The first application processor 503 may correspond to a first thermistor. The first display 509 may correspond to a second thermistor. The at least one processor 503 may obtain the temperature of the first application processor 503 through the first thermistor. The at least one processor 503 may obtain a temperature of the first display 509 through the second thermistor. For example, the variable may be a power consumption. The application processor 503 may operate the first fan 513 based on a power consumption of the application processor 503 equal to or greater than the first threshold. The application processor 503 may operate the first fan 513 with a higher rotational speed as the power consumption of the application processor 503 increases.

The wearable device 501 may not include a second application processor. Even if a single application processor is configured, according to embodiments of the present disclosure, operations using a plurality of heat dissipation fans (e.g., the second fan 517 and the third fan 519) and the above-described heat dissipation structure may be applied. A region occupied by the first fan 513 corresponding to the application processor 503 of the wearable device 501 may be larger than a region occupied by the first fan 413 corresponding to the first application processor 403. A relatively large region may provide a high heat dissipation performance. For example, a rotation area of the first fan 513 may be larger than a rotation area of each of the first fan 413 and the second fan 415 of FIG. 4. For another example, a rotational speed of the first fan 513 may be greater than the rotational speed of each of the first fan 413 and the second fan 415 of FIG. 4.

According to an embodiment, the first display 509 may correspond to the second fan 517. The application processor 503 may operate the second fan 517 based on a variable measurement value of the first display 509. For example, the variable may be a temperature. The application processor 503 may operate the second fan 517 based on a temperature value of the first display 509 equal to or greater than a third threshold. For example, the variable may be a power consumption. The application processor 503 may operate the second fan 517 based on a power consumption of the first display 509 equal to or greater than a second threshold.

According to an embodiment, the second display 511 may correspond to the third fan 519. The application processor 503 may operate the third fan 519 based on a variable measurement value of the second display 511. For example, the variable may be a temperature. The application processor 503 may operate the third fan 519 based on a temperature value of the second display 511 equal to or greater than the third threshold. For example, the variable may be a power consumption. The application processor 503 may operate the third fan 519 based on a power consumption of the second display 511 equal to or greater than the second threshold.

According to an embodiment, the application processor 503 may operate the first fan 513 based on a variable measurement value of the application processor 503. For example, the variable may be a temperature. The application processor 503 may operate the first fan 513 with a higher rotational speed as a temperature value of the application processor 503 is higher. For example, the variable may be a power consumption. The application processor 503 may operate the first fan 513 with a higher rotational speed as a power consumption of the application processor 503 increases.

According to an embodiment, the application processor 503 may operate the second fan 517 based on the variable measurement value of the first display 509. For example, the variable may be a temperature. The application processor 503 may operate the second fan 517 with a higher rotational speed as the temperature value of the first display 509 is higher. For example, the variable may be a power consumption. The application processor 503 may operate the second fan 517 with a higher rotational speed as the power consumption of the first display 509 increases. For example, the variable may be luminance. The application processor 503 may operate the second fan 517 based on luminance of the first display 509 equal to or greater than the first threshold. The application processor 503 may operate the second fan 517 with a higher rotational speed as the luminance of the first display 509 is higher.

According to an embodiment, the application processor 503 may operate the third fan 519 based on the variable measurement value of the second display 511. For example, the variable may be a temperature. The application processor 503 may operate the third fan 519 with a higher rotational speed as the temperature value of the second display 511 is higher. For example, the variable may be a power consumption. The application processor 503 may operate the third fan 519 with a higher rotational speed as the power consumption of the second display 511 increases. For example, the variable may be luminance. The application processor 503 may operate the third fan 519 based on luminance of the second display 511 equal to or greater than the first threshold. The application processor 503 may operate the third fan 519 with a higher rotational speed as the luminance of the second display 511 is higher.

In FIG. 5, the wearable device for providing the virtual image is illustrated to include the third opening 525 and the fourth opening 527, but embodiments of the present disclosure are not limited thereto. According to another embodiment, the wearable device for providing the virtual image may not include the third opening 525 and the fourth opening 527. The second fan 517 and the third fan 519 of the wearable device for providing the virtual image may be a microelectromechanical structure (MEMS) fan. Even if an amount of air inflow is small, the MEMS fan may dissipate heat with strong pressure. The MEMS fan may utilize an ultrasonic wave. The MEMS fan may discharge air introduced through the MEMS fan toward a direction of the first fan 513.

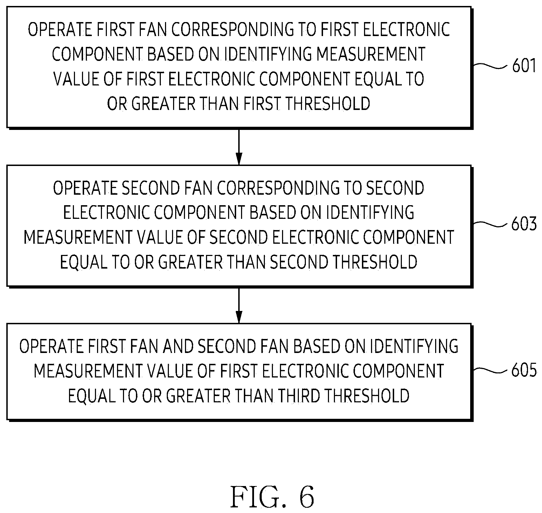

FIG. 6 illustrates a flow of an operation of an electronic device for operating a fan according to an embodiment. Operations of a wearable device (e.g., the wearable device 401) may be performed by at least one processor (e.g., the first application processor 403 of FIG. 4).

Referring to FIG. 6, in an operation 601, the at least one processor (e.g., the first application processor 403 of FIG. 4 or the application processor 503 of FIG. 5) may operate a first fan (e.g., the first fan 413 of FIG. 4 or the first fan 513 of FIG. 5) corresponding to a first application processor 403 or 503 based on identifying a variable measurement value of a first electronic component (e.g., the first application processor 403 of FIG. 4 or the application processor 503 of FIG. 5) equal to or greater than a first threshold.

According to an embodiment, the wearable device for providing the virtual image may operate a plurality of heat dissipation fans (e.g., a first fan 413, a second fan 415, a third fan 417, and a fourth fan 419), even if a temperature of a specific electronic component (e.g., the second application processor 405) among all electronic components (e.g., the first application processor 403, and the second application processor 405) is not equal to or greater than a specified threshold. That is, in case that even one of the electronic components generates heat with a high temperature, not only a fan corresponding to the one electronic component but also all of a plurality of fans may operate to improve a heat dissipation performance.

According to an embodiment, the first application processor 403 or 503 may operate the first fan 413 or 513 based on identifying a temperature measurement value of the first application processor 403 or 503 equal to or greater than the first threshold. For example, the first application processor 403 or 503 may operate the first fan 413 or 513 based on identifying a temperature measurement value of the first application processor 403 or 503 of approximately 45 degrees or more.

According to an embodiment, the first application processor 403 or 503 may operate the first fan 413 or 513 based on identifying a measured value of a power consumption of the first application processor 403 or 503 equal to or greater than the first threshold. For example, the first application processor 403 or 503 may operate the first fan 413 or 513 based on identifying a power consumption value of the first application processor 403 or 503 of approximately 7.5W or more.

According to an embodiment, the at least one processor 403 or 503 may set a rotational speed (e.g., a revolutions per minute (RPM)) of the first fan 413 or 513 corresponding to the first application processor 403 or 503 to be higher as a temperature value of the first application processor 403 or 503 is higher. For example, the at least one processor 403 or 503 may operate the first fan 413 or 513 with a first rotational speed based on a first temperature of the first application processor 403 or 503. The at least one processor 403 or 503 may operate the first fan 413 or 513 with a second rotational speed faster than the first rotational speed based on a second temperature of the first application processor 403 or 503 higher than the first temperature.

According to an embodiment, the at least one processor 403 or 503 may set the rotational speed of the first fan 413 or 513 to be higher as a power consumption of the first application processor 403 or 503 increases. For example, the at least one processor 403 or 503 may operate the first fan 413 or 513 with the first rotational speed based on a first power consumption of the first application processor 403 or 503. The at least one processor 403 or 503 may operate the first fan 413 or 513 with the second rotational speed faster than the first rotational speed based on a second power consumption of the first application processor 403 or 503 greater than the first power consumption.

In an operation 603, based on identifying a variable measurement value of a second electronic component (e.g., the second application processor 405 of FIG. 4, the first display 409 of FIG. 4, or the first display 509 of FIG. 5) equal to or greater than a second threshold, the at least one application processor 403 or 503 may operate a second fan (e.g., the second fan 415 of FIG. 4, the third fan 417 of FIG. 4, or the second fan 517 of FIG. 5) corresponding to the second electronic component 405, 409, or 509.

According to an embodiment, the first application processor 403 or 503 may operate the second fan 415 based on identifying a temperature measurement value of the second application processor 405 equal to or greater than the second threshold. For example, the first application processor 403 or 503 may operate the second fan 415 based on identifying the temperature measurement value of the second application processor 405 of approximately 45 degrees or more.

According to an embodiment, the first application processor 403 or 503 may operate the second fan 415 based on identifying a measured value of a power consumption of the second application processor 405 equal to or greater than the second threshold. For example, the first application processor 403 or 503 may operate the second fan 415 based on identifying a power consumption value of the second application processor 405 of approximately 7.5W or more.

According to an embodiment, the first display 409 or 509 may operate the second fan 417 or 517 based on identifying a temperature measurement value of the first display 409 or 509 equal to or greater than the second threshold. For example, the first application processor 403 or 503 may operate the second fan 417 or 517 based on identifying the temperature measurement value of the first display 409 or 509 of approximately 45 degrees or more.

According to an embodiment, the first application processor 403 or 503 may operate the second fan 417 or 517 based on identifying a power consumption value of the first display 409 or 509 equal to or greater than the second threshold. For example, the first application processor 403 or 503 may operate the second fan 417 or 517 based on identifying a power consumption value of the first display 409 or 509 of approximately 7.5W or more.

According to an embodiment, the at least one processor 403 or 503 may set a rotational speed of the second fan 415 corresponding to the second application processor 405 to be higher as a temperature value of the second application processor 405 is higher. For example, the at least one processor 403 or 503 may operate the second fan 415 corresponding to the second application processor 405 with a third rotational speed based on a third temperature of the second application processor 405. The at least one processor 403 or 503 may operate the second fan 415 with a fourth rotational speed faster than the third rotational speed based on the fourth temperature of the second application processor 405 higher than the third temperature.

According to an embodiment, the at least one processor 403 or 503 may set the rotational speed of the second fan 415 to be higher as a power consumption of the second application processor 405 increases. For example, the at least one processor 403 or 503 may operate the second fan 415 with the third rotational speed based on a third power consumption of the second application processor 405. The at least one processor 403 or 503 may operate the second fan 415 with the fourth rotational speed faster than the third rotational speed based on a fourth power consumption of the second application processor 405 greater than the third power consumption.

According to an embodiment, the at least one processor 403 or 503 may set the rotational speed of the second fan 417 or 517 corresponding to the first display 409 or 509 to be higher as the temperature value of the first display 409 or 509 is higher. For example, the at least one processor 403 or 503 may operate the second fan 417 or 517 with the third rotational speed based on a third temperature of the first display 409 or 509. The at least one processor 403 or 503 may operate the second fan 417 or 517 with the fourth rotational speed faster than the third rotational speed based on the fourth temperature of the first display 409 or 509 higher than the third temperature.

According to an embodiment, the at least one processor 403 or 503 may set the rotational speed of the second fan 417 or 517 to be higher as a power consumption of the first display 409 or 509 increases. For example, the at least one processor 403 or 503 may operate the second fan 417 or 517 with the third rotational speed based on the third power consumption of the first display 409 or 509. The at least one processor 403 or 503 may operate the second fan 417 or 517 with the fourth rotational speed faster than the third rotational speed based on the fourth power consumption of the first display 409 or 509 greater than the third power consumption.

In an operation 605, the at least one application processor 403 or 503 may operate the first fan (e.g., the first fan 413 of FIG. 4 or the first fan 513 of FIG. 5) or the second fan (e.g., the second fan 415 of FIG. 4, the third fan 417 of FIG. 4, or the second fan 517 of FIG. 5) based on identifying a variable measurement value of the first electronic component (e.g., the first application processor 403 of FIG. 4 or the application processor 503 of FIG. 5) equal to or greater than a third threshold. The third threshold may be greater than the first threshold.

According to an embodiment, the at least one processor 403 or 503 may operate the second fan 415 corresponding to the second application processor 405 based on identifying the temperature value of the first application 406 or 506 greater than the third threshold. Even if the temperature value of the second application processor 405 is less than the second threshold, the second fan 415 may operate, in case that the temperature value of the first application processors 403 or 503 is greater than or equal to the third threshold. That is, the second fan 415 may operate to lower the temperature value of the first application processor 403 or 503.

According to an embodiment, the at least one processor 403 or 503 may operate the first fan 413 or 513 corresponding to the first application processor 403 or 503 based on identifying the temperature value of the second application processor 405 equal to or greater than a fourth threshold. The fourth threshold may be greater than the second threshold. Even if the temperature value of the first application processor 403 or 503 is less than the first threshold, the first fan 413 or 513 may operate, in case that the temperature value of the second application processor 405 is equal to or greater than the fourth threshold. That is, the first fan 415 may operate to lower the temperature value of the second application processor 405.

According to an embodiment, the at least one processor 403 or 503 may operate the second fan 415 corresponding to the second application processor 405 based on identifying the power consumption of the first application 406 or 506 greater than the third threshold. Even if the power consumption of the second application processor 405 is less than the second threshold, the second fan 415 may operate, in case that the power consumption of the first application processor 403 or 503 is equal to or greater than the third threshold. That is, the second fan 415 may operate to lower the power consumption of the first application processor 403 or 503.

According to an embodiment, the at least one processor 403 or 503 may operate the first fan 413 or 513 corresponding to the first application processor 403 or 503 based on identifying a power consumption of the second application processor 405 equal to or greater than the fourth threshold. The fourth threshold may be greater than the second threshold. Even if the power consumption of the first application processor 403 or 503 is less than the first threshold, the first fan 413 or 513 may operate, in case that the power consumption of the second application processor 405 is equal to or greater than the fourth threshold. That is, the first fan 415 may operate to lower the power consumption of the second application processor 405.

According to an embodiment, the at least one processor 403 or 503 may set the rotational speed of the second fan corresponding to the second electronic component to be higher as the variable measurement value of the first electronic component greater than the third threshold is higher. For example, the at least one processor 403 may set the rotational speed of the second fan 415 corresponding to the second application processor 405 to be higher as a temperature value of the first application processor 403 greater than the third threshold is higher. For example, the at least one processor 403 may operate the second fan 415 with the first rotational speed based on a first temperature greater than the third threshold of the first application processor 403. The at least one processor 403 may operate the second fan 415 with a second rotational speed faster than the first rotational speed based on a second temperature of the first application processor 403 higher than the first temperature.

For example, the at least one processor 403 or 503 may set the rotational speed of the second fan 417 or 517 corresponding to the first display 409 or 509 to be higher as the temperature value of the first application processor 403 or 503 greater than the third threshold is higher. For example, the at least one processor 403 or 503 may operate the second fan 417 or 517 with the first rotational speed based on the first temperature greater than the third threshold value of the first application processors 403 or 503. The at least one processor 403 or 503 may operate the second fan 417 or 517 with the second rotational speed faster than the first rotational speed based on the second temperature of the first application processors 403 or 503 higher than the first temperature.

For example, the at least one processor 403 may set the rotational speed of the second fan 415 corresponding to the second application processor 405 to be higher as the power consumption of the first application processor 403 greater than the third threshold increases. For example, the at least one processor 403 may operate the second fan 415 with the first rotational speed based on the first power consumption greater than the third threshold of the first application processor 403. The at least one processor 403 may operate the second fan 415 with the second rotational speed faster than the first rotational speed based on the second power consumption of the first application processor 403 greater than the first temperature.

For example, the at least one processor 403 or 503 may set the rotational speed of the second fan 417 or 517 corresponding to the first display 409 or 509 to be higher as the power consumption of the first application processor 403 or 503 greater than the third threshold increases. For example, the at least one processor 403 or 503 may operate the second fan 417 or 517 with the first rotational speed based on the first power consumption greater than the third threshold of the first application processor 403 or 503. The at least one processor 403 or 503 may operate the second fan 417 or 517 with the second rotational speed faster than the first rotational speed based on the second power consumption of the first application processor 403 or 503 greater than the first temperature.

FIG. 6 describes that a heat dissipation fan corresponding to the electronic component operates based on a variable measurement value of the electronic component, but embodiments of the present disclosure are not limited thereto. The at least one processor 403 or 503 may identify active fan information corresponding to the identified application. The at least one processor 403 or 503 may operate a heat dissipation fan included in the active fan information. The heat dissipation fan may operate with a rotational speed of the first step, second step, and third step. The rotational speed may be fast in an order of the third step, the second step, and the first step. The rotational speed of the third step may be the fastest.

For example, when watching a video, the first fan may operate with the rotational speed of the second step. When watching the video, the second fan may not operate. When watching the video, the third fan and the fourth fan may operate with the rotational speed of the second step. For example, when performing a VR game, the first fan may operate with the rotational speed of the second step or the third step.

For example, when performing the VR game, the second fan may operate with the rotational speed of the first step or second step. When performing the VR game, the third fan and the fourth fan may operate with the rotational speed of the second step.

For example, when performing a video see through (VST) operation, the first fan may operate with the rotational speed of the third step. When performing the VST operation, the second fan may operate with the rotational speed of the third step. When performing the VST operation, the third fan and the fourth fan may operate with the rotational speed of the second step. When performing the VST operation, the wearable device for providing the virtual image may display an image of a virtual space corresponding to a rotation angle of the wearable device for providing the virtual image on a display.

For example, when charging a battery, the first fan may operate with the rotational speed of the first step or second step. When charging the battery, the second fan may not operate. When charging the battery, the third fan and the fourth fan may not operate. However, when charging the battery, the second fan may operate based on a temperature equal to or greater than a first reference value. When charging the battery, the third fan and/or the fourth fan may operate based on a temperature equal to or greater than a second reference value. The second reference value may be greater than the first reference value.

For example, when the battery charging and the VR game are performed together, the first fan may operate with the rotational speed of the third step. When the battery charging and the VR game are performed together, the second fan may operate with the rotational speed of the second step. When the battery charging and the VR game are performed together, the third fan and the fourth fan may operate with the rotational speed of the third step.

For example, when the battery charging and the VST operation are performed together, the first fan may operate with the rotational speed of the third step. When the battery charging and the VST operation are performed together, the second fan may operate with the rotational speed of the third step. When the battery charging and the VST operation are performed together, the third fan and the fourth fan may operate with the rotational speed of the second step. For example, a plurality of fans of the wearable device may operate based on a following table.

**[Table 1]**

| | First fan | Second fan | Third fan | Fourth fan |
|---|---|---|---|---|
| Watching the video | second step | OFF | Second step | Second step |
| VR game | Second step, or Third step | First step, or Second step | Second step | Second step |
| VST operation | Third step | Third step | Second step | Second step |
| Charging | First step, or Second step | OFF | OFF | OFF |
| Charging+ VR game | Third step | Second step | Second step | Second step |
| Charging+ VST operation | Third step | Third step | Second step | Second step |

In addition to an example illustrated in the Table 1, the wearable device (e.g., the wearable device 401 or the wearable device 501) may activate at least a portion of the plurality of heat dissipation fans based on various standards. According to an embodiment, the at least one processor 403 and 503 may activate a portion of the plurality of heat dissipation fans based on a memory usage rate. For example, the at least one processor 403 and 503 may rotate only the first fan when the memory usage rate is low. The at least one processor may rotate the first fan and the second fan in case that the memory usage rate is high.

According to an embodiment, the at least one processor 403 and 503 may activate a portion of the plurality of heat dissipation fans based on a type of an application in execution. For example, the at least one processor 403 and 503 may rotate only one of the first fan, the second fan, the third fan, and the fourth fan when a low load application is being executed. The low load application may be an application that does not use a camera. The low load application may be an application that displays a VR-only video. The low load application may be an application for displaying a video. The low load application may be an application for displaying a real-time streaming video.

According to an embodiment, the at least one processor 403 or 503 may activate a portion of the plurality of heat dissipation fans based on at least one of an AP share, a CPU share, or a GPU share. The at least one processor 403 and 503 may activate a portion of the plurality of heat dissipation fans based on the AP share. The at least one processor 403 and 503 may activate a portion of the plurality of heat dissipation fans based on the CPU share. The at least one processor 403 and 503 may activate a portion of the plurality of heat dissipation fans based on the GPU share. For example, the at least one processor 403 and 503 may activate the first fan and the second fan in case that the application processor (AP) share is high. For example, the at least one processor 403 and 503 may activate the first fan and the second fan in case that the central processing unit (CPU) share is high. For example, the at least one processor 403 and 503 may activate the first fan and the second fan in case that the graphic processing unit (GPU) share is high.

According to an embodiment, the at least one processor 403 and 503 may activate a portion of the plurality of heat dissipation fans based on a clock. For example, the at least one processor 403 and 503 may activate the first fan and the second fan in case that the clock is high.

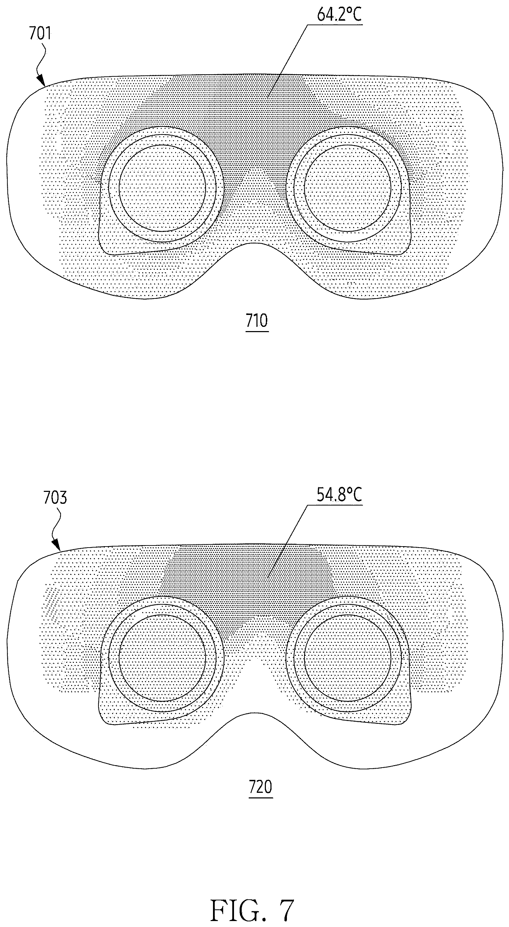

FIG. 7 illustrates a degree of radiation corresponding to the number of fans according to an embodiment.

Referring to FIG. 7, a wearable device 701 for providing a virtual image may include a first application processor (e.g., the first application processor 403 of FIG. 4), a second application processor (e.g., the second application processor 405 of FIG. 4), and a first fan corresponding to the first application processor 403, and the second application processor405. The wearable device 703 for providing the virtual image may include the first application processor 403, the second application processor 405, the first fan (e.g., the first fan 413 of FIG. 4) corresponding to the first application processor, and a second fan (e.g., the second fan 415 of FIG. 4) corresponding to the second application processor. A state 710 is a temperature distribution of the wearable device 701 for providing the virtual image operated for a certain period of time. A state 720 is a temperature distribution of the wearable device 703 for providing the virtual image operated for a certain period of time.

According to an embodiment, in the state 710, a width of a high-temperature region of the wearable device 701 for providing the virtual image may be relatively wider than a width of a high-temperature region of the wearable device 703 for providing the virtual image in the state 720. In the state 710, an average temperature of the high-temperature region of the wearable device 701 for providing the virtual image may be approximately 64.2 degrees. In the state 720, an average temperature of the high-temperature region of the wearable device 703 for providing the virtual image may be approximately 54.8 degrees. In the state 710, the average temperature of the high-temperature region of the wearable device 701 for providing the virtual image may be relatively higher than the average temperature of the high-temperature region of the wearable device 703 for providing the virtual image in the state 720. A heat dissipation performance of the wearable device 703 for providing the virtual image may be better than a heat dissipation performance of the wearable device 701 for providing the virtual image. Since a heat dissipation fan corresponding to the second application processor is added, a heat dissipation performance may be improved.

As described above, according to an embodiment, a wearable device may comprise a housing, a first display disposed in a region of the housing, a second display disposed in another region of the housing, a heatsink, the first application processor, the second application processor, and the heatsink disposed to face the first application processor and the second application processor, a first fan corresponding to the first application processor, a second fan corresponding to the second application processor, a third fan corresponding to the first display, and a fourth fan corresponding to the second display. The wearable device may comprise a housing. The wearable device may comprise a first display disposed in a region of the housing. The wearable device may comprise a second display disposed in the another region of the housing. The wearable device may comprise a heatsink. The wearable device may comprise a first application processor. The wearable device may comprise a second application processor. The wearable device may comprise the heatsink disposed to face the first application processor and the second application processor. The wearable device may comprise a first fan corresponding to the first application processor. The wearable device may comprise a second fan corresponding to the second application processor. The wearable device may comprise a third fan corresponding to the first display. The wearable device may comprise a fourth fan corresponding to the second display. The housing may comprise a first opening, a second opening, a third opening, and a fourth opening. The housing may comprise the first opening. The housing may comprise the second opening. The housing may comprise the third opening. The housing may comprise the fourth opening.

According to an embodiment, the housing may comprise a first surface including the display of the wearable device, a second surface opposite to and spaced apart from the first surface, a first side surface 433 connecting the first surface and the second surface, a second side surface 435 connecting the first surface and the second surface, and a third side surface 437 connecting the first surface and the second surface, opposite to the second side surface 435. The housing may comprise a first surface including the display of the wearable device. The housing may comprise a second surface opposite to and spaced apart from the first surface. The housing may comprise a first side surface 433 connecting the first surface and the second surface, and a second side surface 435 connecting the first surface and the second surface. The housing may comprise a third side surface 437 connecting the first surface and the second surface, opposite to the second side surface 435. The first opening 421 may be formed to penetrate the first side surface 433 of the region of the housing. The second opening 423 may be formed to penetrate the first side surface 433 of the another region of the housing. The third opening 425 may be formed to penetrate the second side surface 435 of the region of the housing. The fourth opening 427 is formed to penetrate the third side surface 437 of the another region of the housing.

According to an embodiment, the housing may comprise a fifth opening 429 for the first fan 413 and the third fan 417, belonging to the region of the housing, and a sixth opening 431 for the second fan 415 and the fourth fan 419, belonging to the another region of the housing. The housing may comprise a fifth opening 429 for the first fan 413 and the third fan 417, belonging to the region of the housing. The housing may comprise a sixth opening 431 for the second fan 415 and the fourth fan 419, belonging to the another region of the housing.

According to an embodiment, the housing may be configured to comprise a first surface including the display of the wearable device, a second surface opposite to and spaced apart from the first surface, a first side surface connecting the first surface and the second surface, a second side surface connecting the first surface and the second surface, a third side surface connecting the first surface and the second surface and opposite to the second side surface, and a fourth side surface connecting the first surface and the second surface, and opposite to the first side surface. The housing may comprise a first surface including the display of the wearable device. The housing may comprise a second surface opposite to and spaced apart from the first surface. The housing may be configured to comprise a first side surface connecting the first surface and the second surface. The housing may be configured to comprise a second side surface connecting the first surface and the second surface. The housing may be configured to connect the first surface and the second surface. The housing may be configured to connect a third side surface opposite to the second side surface, and the first surface and the second surface. The housing may be configured to comprise a fourth side surface opposite to the first side surface. The fifth opening may be formed to penetrate the fourth side surface of the region of the housing. The sixth opening may be formed to penetrate the fourth side surface of the another region of the housing.

According to an embodiment, the first application processor 403 may be configured to execute functions of the wearable device 101, 201, 301, or 401. The second application processor may be configured to execute functions of the first display and the second display.

As described above, according to an embodiment, a wearable device may comprise a housing, a first display disposed in a region of the housing, a second display disposed in another region of the housing, a heatsink, an application processor for executing functions of the wearable device, the heatsink disposed to face the application processor, a first fan corresponding to the application processor, a second fan corresponding to the first display, and a third fan corresponding to the second display. The wearable device may comprise a housing. The wearable device may comprise a first display disposed in a region of the housing. The wearable device may comprise a second display disposed in another region of the housing. The wearable device may comprise a heatsink. The wearable device may comprise the application processor. The wearable device may comprise the heatsink disposed to face the application processor. The wearable device may comprise a first fan corresponding to the application processor. The wearable device may comprise a second fan corresponding to the first display. The wearable device may comprise a third fan corresponding to the second display. The housing may comprise a first opening, a second opening, a third opening, and a fourth opening. The housing may comprise the first opening. The housing may comprise the second opening. The housing may comprise the third opening. The housing may comprise the fourth opening.

According to an embodiment, the housing may comprise a first surface facing a user when the wearable device is worn by the user, a second surface opposite to and spaced apart from the first surface, a first side surface connecting the first surface and the second surface, a second side surface connecting the first surface and the second surface, and a third side surface connecting the first surface and the second surface and opposite to the second side surface. The first opening may be formed to penetrate the first side surface of the region of the housing. The second opening may be formed to penetrate the first side surface of the another region of the housing. The third opening may be formed to penetrate the second side surface of the region of the housing. The fourth opening may be formed to penetrate the third side surface of the another region of the housing.

According to an embodiment, the housing may comprise a fifth opening, for the first fan and the second fan, belonging to the region of the housing, and a sixth opening, for the first fan and the third fan, belonging to the another region of the housing.

According to an embodiment, the housing may comprise a first surface including the display of the wearable device, a second surface opposite to and spaced apart from the first surface, a first side surface connecting the first surface and the second surface, a second side surface connecting the first surface and the second surface, a third side surface connecting the first surface and the second surface and opposite to the second side surface, and a fourth side surface connecting the first surface and the second surface and opposite to the first side surface. The fifth opening may be formed to penetrate the fourth side surface of the region of the housing. The sixth opening may be formed to penetrate the fourth side surface of the another region of the housing.

According to an embodiment, an application processor 403 may execute functions of the wearable device 101, 201, 301, or 401.

As described above, according to an embodiment, a wearable device may comprise a first application processor, a second application processor, a first fan corresponding to the first application processor, and a second fan corresponding to the second application processor. The first application processor may be configured to operate the first fan based on identifying a variable measurement value of the first application processor being equal to or greater than a first threshold. The first application processor may be configured to operate a second fan based on identifying a variable measurement value of the second application processor being equal to or greater than a second threshold. The first application processor may be configured to operate the first fan and the second fan based on identifying the variable measurement value of the first application processor being equal to or greater than a third threshold. The third threshold may be greater than the first threshold.

According to an embodiment, the variable measurement value of the first application processor may be a temperature value of the first application processor. The variable measurement value of the second application processor may be a temperature value of the second application processor.

According to an embodiment, the wearable device may further comprise a first display, a second display, a third fan corresponding to the first display, and a fourth fan corresponding to the second display. The first application processor may be configured to identify an application in execution. The first application processor may be configured to identify active fan information corresponding to the identified application. The first application processor may be configured to operate at least one of the first fan, the second fan, the third fan, or the fourth fan included in the active fan information.

According to an embodiment, the variable measurement value of the first application processor may be a power consumption value of the first application processor. The variable measurement value of the second application processor may be a power consumption value of the second application processor.

According to an embodiment, to operate the first fan, the first application processor may be configured to operate the first fan with a first rotational speed based on a first temperature value of the first application processor. The first application processor may be configured to operate the first fan with a second rotational speed faster than the first rotational speed based on a second temperature of the first application processor that is higher than the first temperature of the first application processor. To operate the second fan, the first application processor may be configured to operate the second fan with a third rotational speed based on a third temperature of the second application processor. The first application processor may be configured to operate the second fan with a fourth rotational speed faster than the third rotational speed based on a fourth temperature of the second application processor that is higher than the third temperature of the second application processor.

According to an embodiment, to operate the first fan, the first application processor may be configured to operate the first fan with a first rotational speed based on a first power consumption of the first application processor. The first application processor may be configured to operate the first fan with a second rotational speed faster than the first rotational speed based on a second power consumption of the first application processor that is greater than the first power consumption of the first application processor. To operate the second fan, the first application processor may be configured to operate the second fan with a third rotational speed based on a third power consumption of the second application processor. The first application processor may be configured to operate the second fan with a fourth rotational speed faster than the third rotational speed based on a fourth power consumption of the second application processor that is greater than the third power consumption of the second application processor.

As described above, according to an embodiment, a method executed by a wearable device may comprise operating a first fan based on identifying a variable measurement value of a first application processor being equal to or greater than a first threshold. The method may comprise operating a second fan based on identifying a variable measurement value of a second application processor being equal to or greater than a second threshold. The method may comprise rotating the first fan and the second fan based on identifying the variable measurement value of the first application processor being equal to or greater than a third threshold. The third threshold may be greater than the first threshold.

According to an embodiment, the variable measurement value of the first application processor may be a temperature value of the first application processor. The variable measurement value of the second application processor may be a temperature value of the second application processor.

According to an embodiment, the method may further comprise identifying an application in execution. The method may further comprise identifying active fan information corresponding to the identified application. The method may further comprise operating at least one of the first fan, the second fan, a third fan, or a fourth fan included in the active fan information.

According to an embodiment, the variable measurement value of the first application processor may be a power consumption value of the first application processor. The variable measurement value of the second application processor may be a power consumption value of the second application processor.

According to an embodiment, the operating the first fan may comprise operating the first fan with a first rotational speed based on a first temperature of the first application processor. The operating the first fan may comprise operating the first fan with a second rotational speed faster than the first rotational speed based on a second temperature of the first application processor that is higher than the first temperature of the first application processor. The operating the second fan may comprise operating the second fan with a third rotational speed based on a third temperature of the second application processor. The operating the second fan may comprise operating the second fan with a fourth rotational speed faster than the third rotational speed based on a fourth temperature of the second application processor that is higher than the third temperature of the second application processor.

According to an embodiment, the operating the first fan may comprise operating the first fan 413 with a first rotational speed based on a first power consumption of the first application processor. The operating the first fan may comprise operating the first fan with a second rotational speed faster than the first rotational speed based on a second power consumption of the first application processor that is greater than the first power consumption of the first application processor. The rotating the second fan may comprise operating the second fan with a third rotational speed based on a third power consumption of the second application processor. The rotating the second fan may comprise operating the second fan with a fourth rotational speed faster than the third rotational speed based on a fourth power consumption of the second application processor that is greater than the third power consumption of the second application processor.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. **In** such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A wearable device comprising:
a housing;
a first display (409) disposed in a region of the housing;
a second display (411) disposed in another region of the housing;
a heatsink (407);
a first application processor (403); and
a second application processor (405), wherein the heatsink (407) disposed to face the first application processor (403) and the second application processor (405);
a first fan (413) corresponding to the first application processor;
a second fan (415) corresponding to the second application processor;
a third fan (417) corresponding to the first display; and
a fourth fan (419) corresponding to the second display,
wherein the housing comprises:
a first opening (421);
a second opening (423);
a third opening (425); and
a fourth opening (427).

2. The wearable device of claim 1,
wherein the housing comprises:
a first surface including the display of the wearable device;
a second surface opposite to and spaced apart from the first surface;
a first side surface (433) connecting the first surface and the second surface;
a second side surface (435) connecting the first surface and the second surface; and
a third side surface (437) connecting the first surface and the second surface, opposite to the second side surface (435),
wherein the first opening (421) is formed to penetrate the first side surface (433) of the region of the housing,
wherein the second opening (423) is formed to penetrate the first side surface (433) of the another region of the housing,
wherein the third opening (425) is formed to penetrate the second side surface (435) of the region of the housing, and
wherein the fourth opening (427) is formed to penetrate the third side surface (437) of the another region of the housing.

3. The wearable device of claims 1 to 2,
wherein the housing comprises:
a fifth opening (429) belonging to the region of the housing; and
a sixth opening (431) belonging to the another region of the housing.

4. The wearable device of claims 1 to 3,
wherein the housing is configured to include:
a first surface including the display of the wearable device;
a second surface opposite to and spaced apart from the first surface;
a first side surface (433) connecting the first surface and the second surface;
a second side surface (435) connecting the first surface and the second surface;
a third side surface (437) connecting the first surface and the second surface and opposite to the second side surface (435); and
a fourth side surface (439) connecting the first surface and the second surface and opposite to the first side surface (433), and
wherein the fifth opening (429) is formed to penetrate the fourth side surface (439) of the region of the housing, and
wherein the sixth opening (431) is formed to penetrate the fourth side surface (439) of the another region of the housing.

5. The wearable device of claims 1 to 4,
wherein the first application processor (403) executes functions of the wearable device (101; 201; 301; 401), and
wherein the second application processor (405) executes functions of the first display and the second display.

6. A wearable device comprising:
a housing;
a first display (509) disposed in a region of the housing;
a second display (511) disposed in another region of the housing;
a heatsink (507); and
an application processor (503), wherein the heatsink (507) disposed to face the application processor;
a first fan (513) corresponding to the application processor;
a second fan (517) corresponding to the first display; and
a third fan (519) corresponding to the second display, and
wherein the housing is configured to include:
a first opening (521);
a second opening (523);
a third opening (525); and
a fourth opening (527).

7. The wearable device of claim 6,
wherein the housing comprises:
a first surface facing a user when the wearable device is worn by the user;
a second surface opposite to and spaced apart from the first surface;
a first side surface (533) connecting the first surface and the second surface;
a second side surface (535) connecting the first surface and the second surface; and
a third side surface (537) connecting the first surface and the second surface and opposite to the second side surface (535),
wherein the first opening (521) is formed to penetrate the first side surface (533) of the region of the housing,
wherein the second opening (523) is formed to penetrate the first side surface (533) of the another region of the housing,
wherein the third opening (525) is formed to penetrate the second side surface (535) of the region of the housing, and
wherein the fourth opening (527) is formed to penetrate the third side surface (537) of the another region of the housing.

8. The wearable device of claims 6 to 7,
wherein the housing comprises:
a fifth opening (529) belonging to the region of the housing; and
a sixth opening (531) belonging to the another region of the housing.

9. The wearable device of claims 6 to 8,
wherein the housing is configured to include:
a first surface including the display of the wearable device;
a second surface opposite to and spaced apart from the first surface;
a first side surface (533) connecting the first surface and the second surface;
a second side surface (535) connecting the first surface and the second surface;
a third side surface (537) connecting the first surface and the second surface and opposite to the second side surface (535); and
a fourth side surface (539) connecting the first surface and the second surface and opposite to the first side surface (533),
wherein the fifth opening (529) is formed to penetrate the fourth side surface (539) of the region of the housing, and
wherein the sixth opening (531) is formed to penetrate the fourth side surface (539) of the another region of the housing.

10. A wearable device comprising:
a first application processor (403);
a second application processor (405);
a first fan (413) corresponding to the first application processor; and
a second fan (415) corresponding to the second application processor, and
wherein the first application processor (403) is configured to:
operate the first fan (413) based on identifying a variable measurement value of the first application processor (403) being equal to or greater than a first threshold,
operate the second fan (415) based on identifying a variable measurement value of the second application processor (405) being equal to or greater than a second threshold, and
operate the first fan (413) and the second fan (415) based on identifying the variable measurement value of the first application processor (403) being equal to or greater than a third threshold, and
wherein the third threshold is greater than the first threshold.

11. The wearable device of claim 10,
wherein the variable measurement value of the first application processor (403) is a temperature value of the first application processor (403), and
wherein the variable measurement value of the second application processor (405) is a temperature value of the second application processor (405).

12. The wearable device of claims 10 to 11, further comprising:
a first display (409);
a second display (411);
a third fan (417) corresponding to the first display; and
a fourth fan (419) corresponding to the second display, and
wherein the first application processor (403) is further configured to:
identify an application in execution,
identify active fan information corresponding to the identified application, and
operate at least one of the first fan (413), the second fan (415), the third fan (417), or the fourth fan (419) included in the active fan information.

13. The wearable device of claims 10 to 12,
wherein the variable measurement value of the first application processor (403) is a power consumption value of the first application processor (403), and
wherein the variable measurement value of the second application processor (405) is a power consumption value of the second application processor (405).

14. The wearable device of claims 10 to 13,
wherein, to operate the first fan (413), the first application processor (403) is configured to:
operate the first fan (413) with a first rotational speed based on a first temperature of the first application processor (403), and
operate the first fan (413) with a second rotational speed faster than the first rotational speed based on a second temperature of the first application processor (403) that is higher than the first temperature of the first application processor (403), and
wherein, to operate the second fan (415), the first application processor (403) is configured to:
operate the second fan (415) with a third rotational speed based on a third temperature of the second application processor (405), and
operate the second fan (415) with a fourth rotational speed faster than the third rotational speed based on a fourth temperature of the second application processor (405) that is higher than the third temperature of the second application processor (405).

15. The wearable device of claims 10 to 14,
wherein, to operate the first fan (413), the first application processor (403) is configured to:
operate the first fan (413) with a first rotational speed based on a first power consumption of the first application processor (403), and
operate the first fan (413) with a second rotational speed faster than the first rotational speed based on a second power consumption of the first application processor (403) that is greater than the first power consumption of the first application processor (403), and
wherein, to operate the second fan (415), the first application processor (403) is configured to:
operate the second fan (415) with a third rotational speed based on a third power consumption of the second application processor (405), and
operate the second fan (415) with a fourth rotational speed faster than the third rotational speed based on a fourth power consumption of the second application processor (405) that is greater than the third power consumption of the second application processor (405).
